(19)

**Europäisches Patentamt**
**European Patent Office**
**Office européen des brevets**

(11)  **EP 4 576 421 A1**

(12)  **EUROPEAN PATENT APPLICATION**
published in accordance with Art. 153(4) EPC

(43) Date of publication:
**25.06.2025 Bulletin 2025/26**

(21) Application number: **23854840.8**

(22) Date of filing: **09.08.2023**

(51) International Patent Classification (IPC):
$H01P\ 7/08$ (2006.01)  $G01N\ 22/00$ (2006.01)
$H01P\ 1/203$ (2006.01)  $H01P\ 11/00$ (2006.01)
$H10N\ 60/10$ (2023.01)

(52) Cooperative Patent Classification (CPC):
**G01N 22/00; H01P 1/203; H01P 7/08; H01P 11/00;
H10N 60/10;** Y02E 40/60

(86) International application number:
**PCT/JP2023/029041**

(87) International publication number:
**WO 2024/038806 (22.02.2024 Gazette 2024/08)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **16.08.2022 JP 2022129567**

(71) Applicant: **RIKEN**
**Wako-shi, Saitama 351-0198 (JP)**

(72) Inventors:
 • **MIMA, Satoru**
  **Wako-shi Saitama 351-0198 (JP)**
 • **TAINO, Toru**
  **Wako-shi Saitama 351-0198 (JP)**
 • **MURAYAMA, Ryosuke**
  **Wako-shi Saitama 351-0198 (JP)**
 • **NOGUCHI, Takashi**
  **Wako-shi Saitama 351-0198 (JP)**
 • **OTANI, Chiko**
  **Wako-shi Saitama 351-0198 (JP)**

(74) Representative: **Huebner, Stefan Rolf**
**Postfach 101317**
**80087 München (DE)**

(54)  **SUPERCONDUCTIVE PASSIVE ELEMENT, MANUFACTURING METHOD FOR SUPERCONDUCTIVE PASSIVE ELEMENT, AND DEVICE INCLUDING SAID PASSIVE ELEMENT**

(57)    To reduce the loss of superconductive passive elements, the superconductive passive element 100 of the embodiment of the present disclosure includes a first conductor part 1 having a deposited superconductor and a second conductor part 2 having a superconductor. Here, the first conductor part is separated from the second conductor part, the outermost surface 11 of the superconductor deposited on the first conductor part being opposite the second conductor part. Preferably, the superconductor of the second conductor part is one that has been deposited, and the first conductor part and the second conductor part are arranged with their respective outermost surfaces 11, 21 facing each other and separated from each, as in the superconductive passive element 100A. In the embodiment of the present disclosure, a method for manufacturing the above superconductive passive element is also provided.

**FIG. 5A**

EP 4 576 421 A1

**FIG. 5B**

**FIG. 5C**

## Description

Technical Field

This disclosure relates to a superconducting passive element, a method for manufacturing a superconductive passive element, and an apparatus comprising the passive element. More specifically, this disclosure relates to a low-loss passive element that utilizes the performance of superconductivity for high-frequency applications, a method for fabricating the passive element, and an apparatus comprising the passive element.

Background Art

Passive devices that use superconducting materials, such as resonant elements (hereinafter referred to as "superconductive passive elements"), are known. Superconductive passive elements include those that use superconducting thin films formed on a substrate in a predetermined transmission line pattern, which are cooled down to allow the superconductor to transition to a superconducting state. Examples of these include microwave kinetic inductance detectors (MKIDs) and superconducting quantum computers. These use superconductive resonator elements that use superconductive transmission lines in their structure. Such superconductive resonator elements are examples of superconductive passive elements.

The MKID is an element for detecting external electromagnetic waves in the millimeter wave, terahertz, and far-infrared bands, as well as external radiation including X-rays, gamma rays, and charged particles (hereinafter collectively referred to as "electromagnetic waves and the like"). The MKID has a feedline and a resonator that is AC coupled therewith. In the MKID, high-frequency microwave power is supplied from one end of the feed line, and the power signal transmitted through the feed line is detected at the other end of the feed line. The transmission properties of the feed line reflect the frequency response and phase response of the resonator coupled to it, so at the resonance frequency the power is absorbed by the resonator resulting in a dip in the frequency spectrum (called a "resonance dip"). When the change in this resonance dip is detected based on the transmission properties of the feed line, it is possible to determine the energy carried by the external electromagnetic waves and the like. To improve the detection sensitivity in the MKID for external electromagnetic waves and the like., it is necessary to increase the quality of the resonance (i.e. the resonance Q value) of the resonator made of the superconductor. The resonance Q-value ($Q_{res}$) is calculated by dividing the resonance frequency ($f_{res}$) by the resonance bandwidth ($\Delta f_{res}$) to obtain $Q_{res} = f_{res} / \Delta f_{res}$.

Another example of superconducting transmission lines as superconductive passive elements is the superconducting quantum bit used in superconducting quantum computers. The superconducting quantum bit is made up of a Josephson junction and a superconducting resonator, and the superconducting resonator is used to maintain quantum states and to reduce external noise. One of the performance indicators of such circuits is the time over which the quantum state can be maintained, or coherence time, which is determined by the quality of the resonance (resonance Q value) of the resonator made of the superconductor. In other words, if a higher resonance Q value can be obtained, the time over which the quantum state can be maintained will be longer, leading to a significant contribution to the realization of quantum computers (for example, see Non-Patent Document 1).

In addition to those that use superconducting transmission line structures formed on a substrate, a cavity resonator using bulk superconductors has also been developed for particle accelerators as a microwave resonator using superconductors (Non-Patent Document 2). This is a resonator with an internal resonator space structure (cavity) formed inside a bulk superconductor, and is around several tens of centimeters in size. The best resonance Q value achieved with existing cavity resonators like this, which are used to achieve more efficient acceleration of charged particles, is around $10^{12}$ (one trillion) at 5 GHz and a drive temperature of 2 K (Kelvin). In addition, a photon detection device using a cavity resonator on the order of centimeters has also been achieved using the knowledge acquired from this cavity resonator (Non-Patent Document 3).

The feed lines of the MKID and the parts of the resonator as well as the parts of the superconducting quantum bit described above adopt superconducting transmission lines formed on a single substrate that serves as a conductor in the microwave range. Superconducting transmission lines are typically constructed using microstrip line (MSL) or coplanar waveguide (CPW) structures. In MSL and CPW, the superconductor deposited on a substrate or dielectric is patterned to form a desired pattern.

Citation List

Non-Patent Document(s)

Non-Patent Document 1: Yasunobu Nakamura, "Chodendo Ryoshi Bitto Kenkyuu No Shinten To Oyo" ("Progress and Applications of Superconducting Quantum Bit Research"), Oyo Buturi ("Applied Physics"), Vol. 90, No. 4, 209 (2021), DOI: 10.11470/oubutsu.90.4_209, [in Japanese]

Non-Patent Document 2: A. Romanenko, A. Grassellino, A. C. Crawford, D. A. Seregatskov, and O. Melnychuk, "Ultra-high quality factors in superconducting niobium cavities in ambient magnetic fields up to 10 mG", Appl. Phys. Lett, 105, 234103 (2014), DOI: 10.1063/1.4903808

Non-Patent Document 3: S. Kono, K. Koshino, Y. Tabuchi, A. Noguchi, and Y. Nakamura, "Quantum non-demolition detection of an itinerant microwave photon", Nature Physics, 14, pp. 546-549 (2018), DOI: 10.1038/s41567-018-0066-3

Non-Patent Document 4: A. Endo et al., "First light demonstration of the integrated superconducting spectrometer", Nature Astronomy, 3, 989 (2019), DOI: 10.1038/s41550-019-0850-8

Summary of Disclosure

Technical Problem

Various efforts have been made to increase the resonance Q-value of the MKID and superconducting quantum bits described above. However, with current technology, the resonance Q-value of the MKID and superconducting quantum bits does not reach the value predicted from the physical properties of bulk materials of the same kind of superconductor, and the current reality is that it only reaches around several hundred thousand, and it is extremely difficult to reach around one million. For example, in the case of a substrate made of silicon, the resonance Q-value will remain at around $10^5$ to $10^6$, even if the resonance Q-value of the superconductor is maximized.

In addition, there are also troublesome problems that arise in the real world when making and using conventional superconductive passive components. In the step of cleaning the substrate of superconductive passive components, chemicals that require extreme care (such as hydrofluoric acid) are used to improve the quality of the deposited superconductor. Even in the step of using the manufactured MKID, to maximize the performance of the superconducting properties, it is necessary to cool the device to a cryogenic temperature at or below 100 mK, which requires large-scale cooling equipment such as dilution refrigerators. For example, in superconducting resonators using niobium (superconducting transition temperature $T_c = 9.2$ K), which is the most commonly used superconducting material, a practical level of resonance Q-value has not been observed at liquid helium temperature ($T_c = 4.2$ K), and it is not possible to apply it in practical use by simply adopting a simple cooling method (for example, a mechanical refrigerator such as a GM refrigerator or a pulse tube refrigerator). These conditions also hold true for other superconducting devices than MKIDs (e.g., superconducting qubits) as long as they employ conventional superconductive resonator elements.

The present disclosure is intended to solve at least some of the problems described above. The present disclosure contributes to the development of superconductive passive elements and devices using them by providing a highly practical approach that greatly improves the performance of superconductive passive elements in any device using them.

Solution to Problem

The present inventors noted that some superconductive passive elements, such as conventional superconductive resonator elements, use structures such as MSL and CPW formed on a single substrate. They also speculated that, in superconductive passive elements that use superconductive properties, the performance and practicality of the elements are directly affected by the characteristics of the superconductive transmission line structures that make up each part of the element, and by the dielectric properties of the materials in the positions where the electric fields created by the superconductive transmission lines apply. For example, if the same superconducting performance as bulk superconducting materials can be achieved in MKIDs and superconducting quantum bits, and if there is no dielectric material that is affected by the superconducting transmission lines, or if the properties of the dielectric material are good, it will be possible to achieve a sufficiently large resonance Q value, improve sensitivity, and maintain the quantum state for a long time. If superconductive passive elements can be operated using only a simple cooling device, the practicality of devices that incorporate superconductive passive elements can be improved.

The present inventors have confirmed that the performance of the superconductive passive element can be improved by changing the structure of the conductor part, which is used in pairs, and the structure around the conductor part, and that the resonance Q value of the superconductive resonance element, for example, can be greatly improved, and have completed the superconductive passive element of this disclosure. In other words, the present disclosure provides: a superconductive passive element, comprising. a first conductor part having a superconductor, and a second conductor part having a superconductor, wherein the first conductor part is configured such that an outermost surface of the superconductor of the first conductor part is facing the second conductor part while being separated from the second conductor part.

In addition, the present disclosure provides a superconducting resonator element that comprises the above-mentioned superconductive passive element with a significantly improved resonance Q value.

Furthermore, the present disclosure provides: a method for manufacturing a superconductive passive element, comprising: arranging a first conductor part including a superconductor in opposition to a second conductor part including a superconductor while keeping a distance from the second conductor part.

The superconductive passive elements provided in this disclosure include superconductive resonator elements and measurement cells. Furthermore, this disclosure also provides devices that include any of the superconductive passive elements described in this disclosure.

Unless otherwise specified, the term "superconductor" refers to any object that can be made to transition into a superconducting state, and the material is not particularly limited. This superconductor typically refers to a BCS-type superconductor, and also includes high-temperature superconductors. The superconductor is used after being cooled below the superconducting critical temperature for the operation.

The outermost surface of the superconductor in the present disclosure is at least a part of the outermost surface of the superconductor that is not supported by another object at the step of forming a passive element (e.g., a resonant element). In the case of a superconductor formed in the form of a thin film by using a kind of supporting substrate, the outermost surface is at least a part of the surface where the thickness of the superconductor is defined by the interface between the superconductor on the supporting substrate side and the outermost surface. In addition, when the superconductor has a shape similar to that of the bulk material, such as a wire, foil, beam, plate, or cylinder, the outermost surface simply means at least a surface part of the bulk material that fills the shape. In this disclosure, the term "substrate" refers to any object that serves as a base to support the superconductor during deposition, and its shape is not limited; and does not necessarily have to be a plate shape. If, for any reason, the superconductor is processed to reduce its thickness so that the outermost surface is removed after the superconductor is deposited, the term "outermost surface of the superconductor" refers to the outermost surface after the thickness has been reduced. The term "recess" refers to a portion that has been displaced from a hypothetical plane that smoothly connects the surrounding area, thereby defining the recess in general. In this application, the two-dimensional shape projected onto the hypothetical plane of the recess is not restricted, and instead of forming a recess, it is also possible to form a similar structure using upper and lower substrates with an object inserted therebetween.

A superconductive passive element is a functional element that exhibits a response based on any kind of laws of physics in a superconductive state. This includes superconductive transmission lines, i.e. passive elements that function to transmit signals or power through themselves, and passive elements that exhibit functions using quantum effects, such as superconductive circuits. The term "circuit" refers to any of the circuits that interconnect integrated circuits and discrete components; and is generally composed of a combination of circuit elements (including wiring and transmission lines). These circuit elements can be roughly divided into active elements such as transistors and passive elements, which are elements that do not include active elements. The passive elements in this application are also intended as such. That is, the passive elements in this application include all circuit elements that are not themselves recognized as active elements, and which perform a function freely in combination with any other circuit element, including not only elements that exhibit a linear response, but also elements that exhibit a non-linear response. The passive elements in this application are intended to be used by being incorporated into or connected to a part of a circuit. Non-limiting examples of superconductive passive elements in this application being used to perform a given function either independently or in combination with other circuit elements are resonant circuits and amplification circuits. In other words, the parts used as wiring or transmission lines in those circuits can also be called superconductive passive elements in the present application. A superconductive passive element is a passive element that includes at least one part that transitions to a superconductive state under appropriate conditions.

Advantageous Effects of Disclosure

In one aspect of the present disclosure, a high-performance, highly practical superconductive passive element, a method for manufacturing the same, and a device that uses the superconductive element are provided.

Brief Description of Drawings

FIGS. 1A-B are a plan view (FIG. 1A) illustrating the conventional MKID example structure and a graph (FIG. 1B) indicating its detection operation.
FIGS. 2A-B are explanatory diagrams illustrating the schematic diagrams of the superconducting transmission line structures and the electric field states of two structures of the conventional superconductive passive elements, namely, a microstrip line (FIG. 2A) and a coplanar waveguide (FIG. 2B).

FIG. 3 is an equivalent circuit diagram that can express the electrical behavior of the divided transmission lines of the superconductive passive elements of the embodiment of the present disclosure and the conventional superconducting transmission lines.

FIGS. 4A-E are explanatory diagrams illustrating the concept of differences in superconducting transition temperature at each part over the thickness direction of the superconducting thin film, and are cross-sectional diagrams cutting through the thickness of the deposited superconducting thin film (FIGS. 4A-D) with a legend for the scale of the superconducting transition temperature applied to those cross-sectional diagrams (FIG. 4E).

FIGS. 5A-C are schematic cross-sectional diagrams illustrating the structure of a conventional MSL (FIG. 5A) and the cross-sectional structure of the superconductive passive element of the present disclosure (FIGS. 5B and 5C).

FIG. 6 is an example of a schematic cross-sectional diagram indicating a structure that performs the electrode structure of the superconductive passive element of the present disclosure shown in FIG. 5C using multiple substrates.

FIG. 7 is a flowchart indicating a method for manufacturing an example sample of an embodiment of the present disclosure.

FIGS. 8A-B are design drawings of the photomask used for patterning the lift-off process to fabricate the test sample of the embodiment of the present disclosure, for the resonator substrate (FIG. 8A) and the GND substrate (FIG. 8B).

FIGS. 9A-B are photographs of the resonator substrate (FIG. 9A) and GND substrate (FIG. 9B) after patterning for the sample of the embodiment of the present disclosure.

FIGS. 10A-C are graphs showing the measured performance of the resonant dip of the MKID, which is an example sample of the superconductive passive element of the present disclosure, when cooled to 300 mK. The graphs show the performance of the frequency band by narrowing the frequency range in the order of FIGS. 10A-10C.

FIGS. 11A-C show the spectra of the same transmission coefficient $S_{21}$ near the resonance frequency of each resonator of the sample of the superconductive passive element of the present disclosure at the liquid helium temperature (4.2 K).

FIGS. 12A-C show the spectra of the similar transmission coefficient $S_{21}$ near the resonance frequency of each resonator of the sample of the superconductive passive element of the present disclosure at the liquid helium temperature (4.2 K).

Description of Embodiments

The embodiment of a superconductive passive element of the present disclosure is described below with reference to the drawings. Common reference numerals are given to common parts or elements, unless otherwise noted in the description. In addition, each element in each embodiment should not be understood as not being drawn to scale.

1. Conventional Superconductive Passive Elements

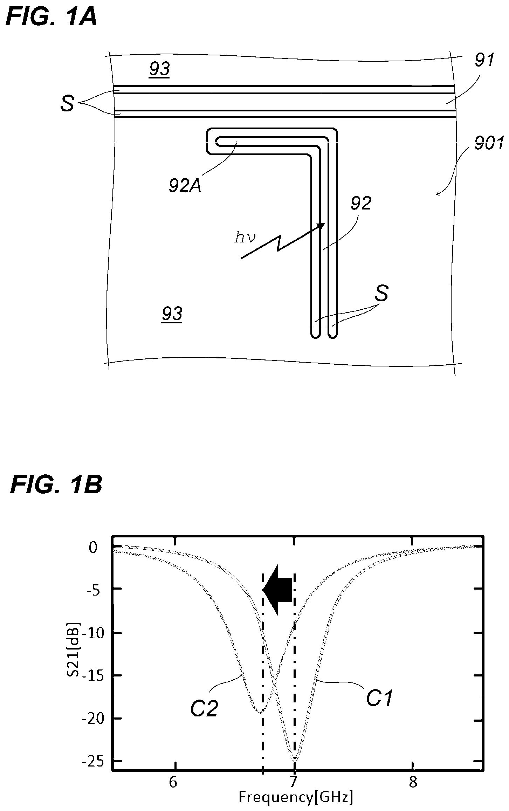

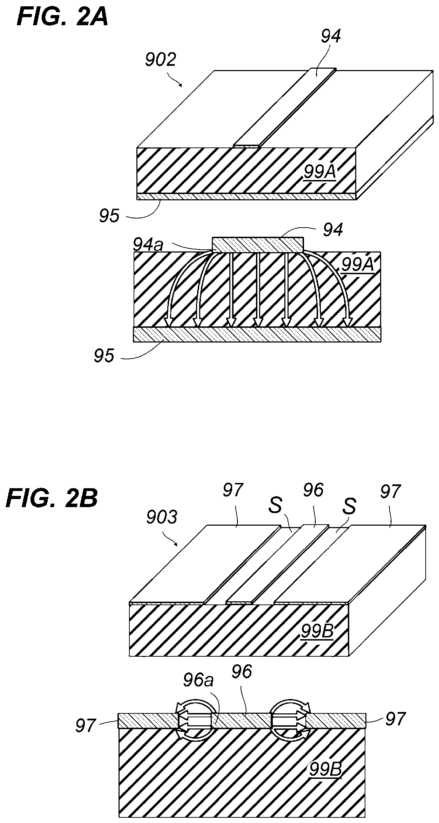

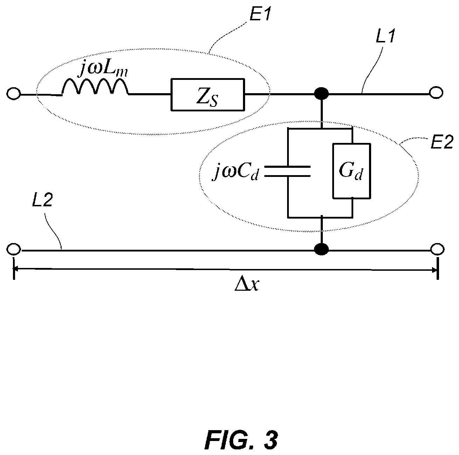

FIGS. 1A and 1B are a plan view (FIG. 1A) of an example structure of a conventional microwave kinetic inductance detector (MKID) and a graph (FIG. 1B) illustrating its detection operation. FIGS. 2A and 2B are explanatory diagrams illustrating the schematic diagram of the superconducting transmission line structure and the state of the electric field in two structures that are widely used in conventional superconductive passive elements. FIG. 3 is an equivalent circuit diagram that can express the electrical behavior of the divided transmission lines of the superconductive passive element of the present embodiment and the conventional superconducting transmission line.

In general, a resonator is a type of element in a high-frequency circuit, and for example, a cavity-shaped cavity has the property of confining high-frequency waves within a certain space. Within the resonator, electromagnetic waves of frequencies that satisfy the resonance conditions are confined. In this structure, the smaller the loss within the resonator, the longer it is possible to confine high-frequency waves within the space, and the smaller the loss, the sharper the dip-shaped spectral shape of the resonance structure in the frequency space.

MKID is a superconducting resonator or superconducting resonator element that uses a superconductor instead of a cavity, and is a type of superconductive passive element. MKID forms a resonant circuit using a superconductor. The resonator can be a resonator made up of a quarter-wavelength transmission line or a half-wavelength transmission line with a microstrip line structure or a coplanar waveguide structure for a distributed-element model, or a resonator made up of an inductor and a capacitor with a meander structure for a lumped-element model. The resonance performance of the MKID, which is the frequency at which it resonates, is determined by the kinetic inductance of the Cooper pairs of electrons in the superconducting state of the superconductors that make up the MKID. In a superconducting resonator, which is a superconductive passive element, the resonance frequency is determined by the number of quasiparticles (the number of normal conduction electrons) and the number of superconducting electrons (the number of Cooper pairs) in the superconductor. When the MKID is placed in a temperature range far below the superconducting transition temperature $T_c$, the number of superconducting electrons in the superconductor remains almost constant, and the resonance frequency of the MKID varies mainly according to the number of quasiparticles. When an external electromagnetic wave or other disturbance arrives at the MKID in this state, Cooper pairs are destroyed in the superconductor creating quasiparticles. This causes a change in the mechanical inductance of the MKID, resulting in a shift in the resonance frequency. In addition, the increase in quasiparticles accompanying the destruction of Cooper pairs leads to a shallowing of the resonance peak.

Conventional MKIDs are made by forming a superconductor such as niobium (Nb) in the form of a thin film on one side of a dielectric substrate (e.g. a single-crystal silicon wafer) and patterning it. As shown in FIG. 1A, in the conventional MKID 901, a slit S is patterned in the superconductor thin film to form a separation line, and a feed line 91, a resonator 92 coupled to the feed line by AC, and a GND electrode 93 are formed. In other words, the feed line 91 has a structure in which the superconducting thin film is not in contact with the surrounding GND electrode 93 in most parts due to the slits S, where the superconducting thin film has been removed on both sides of the superconducting thin film. Specifically, the resonator 92 is structured so that a certain length from one end forms the coupling section 92A, and the part of the resonator 92 other than the coupling section 92A is separated from the feed line 91. The coupling section 92A is formed so that it extends parallel to the feed line 91 for AC coupling. In addition, the other end of the resonator 92 is integrated with the GND electrode 93 at the discontinuity of the slit S and is electrically connected. When in use, the MKID 901 is cooled to around 100 mK, for example, to maintain the superconducting film in a superconducting state.

FIG. 1B is a graph showing the transmission coefficient $S_{21}$, which is the voltage ratio transmitted through the feed line of the conventional MKID 901. As microwave energy is stored in the resonator 92, the transmission characteristics (curve C1) of the microwave in the feed line 91 show a dip at the resonance frequency. When an external electromagnetic wave hv ($> 2\Delta$, where $\Delta$ is the superconducting gap energy) arrives at the resonator 92, it destroys the Cooper pairs in the superconducting body that makes up the resonator 92, and creates quasiparticles (electrons). The creation of these electrons changes the number of quasiparticles (the number of electrons) and the dynamic inductance in the resonator 92, and as a result, the transmission property changes as shown in curve C2. This change causes the frequency at which the dip appears to shift to the low-frequency side and the depth of the dip to become shallower. The change in the actual transmission property depends on the energy of the incoming electromagnetic wave. Although not shown in the figure, the effect of the resonance of the resonator 92 also appears in the phase response. In the MKID, if a sharp dip is obtained by increasing the sharpness of the resonance, even a slight change in the transmission property can be easily detected, so the detection sensitivity for external electromagnetic waves can be improved.

The sharpness of this dip shape is called the resonance Q value. In order to increase the Q value of a resonator, it is generally important to reduce the number of quasiparticles in the resonator as much as possible, and in order to do this, it is important to reduce the number of residual quasiparticles in the superconductor used in the resonator as much as possible. In addition, in general, higher resonance Q values lead to better performance and signal retention times in superconducting detectors and superconducting quantum computers, which are types of superconductive passive elements.

When you look at components of a superconducting resonator such as the MKID901, you will find that it is a superconducting transmission line. There are two main types of superconducting transmission line. One typical example is the microstrip line (MSL, FIG. 2A) 902. In the MSL 902, a superconductor is formed in the form of a thin film on both sides of the film-shaped dielectric 99A. The dielectric 99A is made of various materials, but typically silicon dioxide ($SiO_2$) or sapphire ($Al_2O_3$). On one side of the dielectric 99A, i.e. on the surface corresponding to the lower side of the picture plane in FIG. 2A, the entire superconducting thin film 95, which is formed over a sufficiently wide area, is maintained at a constant electrical potential. The superconducting thin film 95 is typically electrically grounded. In contrast, on the other side, i.e. the upper surface, the superconducting thin film 94, which is formed to have a pattern of fine lines extending in one direction, serves as a path for transmitting signals and electrical power. The entire device, including the superconducting thin films 94 and 95 on both sides of the dielectric 99A, is cooled to induce a superconducting transition. The dielectric 99A induces an electric field that produces the white arrowhead lines in FIG. 2A, corresponding to the potential difference between the superconducting thin films 94 and 95 on both sides, and the dielectric constant of the dielectric 99A is responsible for a distributed capacitance induced in the superconducting thin films 94 and 95.

In another typical example of a superconducting transmission line, the coplanar waveguide (CPW, FIG. 2B) 903, a shield electrode 97 forming a line and the surrounding GND is formed on one side of a freely chosen substrate 99B, such as a single crystal silicon wafer, and a slit S, in which there is no superconductor, is provided between them to form a separation line. The conventional MKID 901 shown in FIG. 1A is also based on CPW. In CPW 903, an electric field is formed between the line 96 and the shield electrode 97 in a direction across the slit S to serve as a separation line. This electric field also extends into the substrate 99B, as indicated by the white arrow, and induces a large electric flux density according to the dielectric constant of the substrate. The transmission line 96 is electrostatically coupled to the surrounding shield electrode 97 and serves as a line with distributed parameters.

An equivalent circuit diagram that can represent the electrical behavior of the segmented transmission lines of conventional superconducting transmission lines (including MSL902 and CPW903) is shown in FIG. 3. This equivalent circuit is shown as a four-terminal circuit, and it can reproduce the high-frequency transmission performance of the two conductors, lines L1 and L2, in an equivalent manner when the direction in which the line extends is represented by x and that direction is divided into a small length of $\Delta$x. Line L1 is represented by a lumped element E1, which is a series connection of an inductor that generates an inductance component $j\omega L_m$ (j is the imaginary unit) per unit length for a given angular frequency $\omega$ and a resistor that generates a resistance component $Z_S$ per unit length. The complex impedance of the lumped constant element E1 expresses the inductance and resistance components contained in the pair of superconducting thin films 94 and 95 in MSL902 (FIG. 2A) and the pair of line 96 and shield electrode 97 in CPW903 (FIG. 2B). Similarly, line L1 is represented by a concentrated constant element E2, which is a parallel connection of a capacitor that generates a capacitance component $j\omega C_d$ per unit length and a resistor that generates a conductance component $G_d$ per unit length, between lines L2. The complex impedance of the lumped constant element E2 expresses the parasitic capacitance component and the associated leakage component between the conductors that make up the pair of superconducting thin films 94 and 95, or the pair of transmission lines 96 and shielding electrodes 97. In actual devices, the complex impedance of the lumped element E2 mainly reflects the dielectric properties of the region where the electric lines of force converge in the dielectric 99A in MSL902 (FIG. 2A) and the region where the electric lines of force converge in the substrate 99B in CPW903 (FIG. 2B). By cascading the four-terminal circuit in FIG. 3, it is possible to describe the properties of a real transmission line with any length in the direction in which the line extends as a distributed-element model. The equivalent circuit in FIG. 3 can express the operation of not only conventional superconducting transmission lines but also the present embodiment of a superconductive passive element..

2. Supeconductive Passve Element in the Present Embodiment.

2-1. Concept.

In the present embodiment of the present disclosure, at least one of the following three findings obtained by the inventors is utilized. The first is that when a structure is formed in which a dielectric (e.g. a supporting substrate) is present in the electric field generated by a superconductor, the dielectric loss exhibited by the dielectric may determine the upper limit of performance. Secondly, in the case of a superconductor deposited on a substrate, the properties of the superconductor may be affected by the substrate during the deposition process, depending on the deposition method employed. Thirdly, on the other hand, as the thickness of the superconductor increases during deposition, the effect of the substrate on the superconductor may be reduced, and the intrinsic properties of the superconductor may become more dominant at the outermost surface of the superconductor, compared to the substrate side. Furthermore, the above-mentioned second and third findings do not always apply in the case of superconductors that have been epitaxially grown, so we will explain them separately in the next section, and for the time being we will explain them on the assumption that the deposition process is by sputtering or vapor deposition.

Even in superconducting resonator elements with a structure like the MSL902 and CPW903 shown in FIGS. 2A and 2B, various innovations have been made to improve performance, but the performance is still insufficient. For example, when a superconducting thin film is formed using a deposition method such as evaporation or sputtering in the structure of a conventional MSL or CPW, it is often the case that the superconducting performance that can be expected from a bulk material of the same temperature cannot be obtained. The same is true for CPW.

In this regard, the present inventors paid attention to the fact that, with regard to the first point above, the points at which deviations from the ideal superconducting properties occur in the superconductor and the points at which the electric field acts on the superconductor and significantly affects the signal and power transmission performance are both positions through which the electric force lines pass, for example, inside the dielectric 99A or inside the substrate 99B, as shown in FIGS. 2A and 2B. In such a region, it is thought that there is an excess energy loss in the dielectric through which the electric flux lines pass in the vicinity of the superconductor. This loss is expressed by the conductance $G_d$ of the lumped-element model E2 in the equivalent circuit in FIG. 3. By improving the quality of the superconducting thin film, the impedance $Z_s$, which denotes the loss of the lumped-element model E1 in the equivalent circuit in FIG. 3, can be sufficiently reduced, and the resonance Q value derived from the superconductor can be increased. However, the dielectric loss of Si at extremely low temperatures is around $10^{-5}$ to $10^{-6}$. This is the reason the resonance Q-value remains around $10^5$ to $10^6$, regardless of how large the resonance Q-value derived from the superconductor is, in structures that use Si for the dielectric 99A and substrate 99B. Here, in the case when the dielectric loss is negligible, the resonance Q-value is given by the ratio of the number of superconducting electrons (Cooper pair) to the number of quasiparticles. While the resonance frequency remains almost constant regardless of the power (or voltage amplitude) of the RF signal supplied to the feed line, the resonance Q value is significantly dependent on the power (or voltage amplitude) of the RF signal and varies mainly according to the number of quasiparticles. Therefore, in order to increase the resonance Q value, it is important to reduce the number of quasiparticles in the resonator as much as possible, and in order to do this, it is important to reduce the number of residual quasiparticles in the superconductor used in the resonator as much as possible. On the other hand, in the case when dielectric loss is not negligible, the reciprocal of the resonance Q-value is given by the sum of the reciprocal of the Q-value of the resonator made of superconductor only and the dielectric loss.

In more detail, the impedance $Z_s$ of the lumped constant element E1 is expressed as

[Math 1]

$$Z_s = R_s + j\omega L_s \,,$$

where, $R_s$ is the real component (resistance component) of the lumped-element model E1 impedance, and $\omega L_s = X_s$ is the mechanical inductance of the lumped-element model E1. Using the total inductance component ($L_T = L_S + L_m$) contained in the impedance component of the lumped-element model E1, the propagation constant (propagation constant) $\gamma_{TL}$ of the equivalent circuit shown in FIG. 3 can be expressed as

[Math 2]

$$\gamma_{TL} = \alpha + j\beta$$

$$\alpha = \frac{\omega\sqrt{L_T C_d}}{2}\left(\frac{R_s}{\omega L_T} + \frac{G_d}{\omega C_d}\right) = \frac{\beta}{2}\left(\frac{1}{Q_{TR}}\right)$$

$$\beta = \omega\sqrt{L_T C_d}$$

Here, the resonance Q-value $Q_{TR}$ of the equivalent circuit in FIG. 3 is the same as the internal Q-factor $Q_i$ of the resonator, and

[Math 3]

$$Q_{TR} \approx Q_i$$

holds. If we use this relationship for the real part $\alpha$ of the propagation constant, we obtain

[Math 4]

$$\frac{1}{Q_i} = \frac{R_s}{\omega L_T} + \frac{G_d}{\omega C_d} \,.$$

The first term on the right-hand side of this equation is the value obtained by dividing the resistance component of the superconductor in the lumped element E1 by the inductance component (multiplied by the angular frequency) of the lumped element E1, and is determined by the properties of the superconductor. In contrast, the second term on the right-hand side is the value obtained by dividing the conductance component $G_d$ of the lumped element E2 by the capacitance component (multiplied by the angular frequency) of the lumped element E2, and is determined by the properties of the dielectric. The first term on the right-hand side can be rewritten as

[Math 5]

$$\frac{1}{Q_{SC}},$$

i.e, it can be rewritten as Qsc, a quantity of the same dimension as the resonance Q-value given only by superconductors. The second term on the right-hand side indicates dielectric loss (tan δ). Therefore,

[Math 6]

$$\frac{1}{Q_i} \approx \frac{1}{Q_{SC}} + \tan\delta$$

still holds. When a high-quality superconducting film is formed and cooled to a sufficiently low temperature, the real component (resistance component) $R_s$ of the impedance of the lumped parameter element E1 approaches zero. In other words,

[Math 7]

$$\frac{1}{Q_{SC}} \to 0 \ (R_s \to 0)$$

still holds. Therefore, when a high-quality superconducting film is formed and cooled to a sufficiently low temperature, the internal resonance Q-value $Q_i$ becomes

[Math 8]

$$\frac{1}{Q_i} \to \tan\delta$$

and is controlled by dielectric loss. In this way, when the resonance Q-value of the superconductor alone becomes extremely large, the resonance Q-value is given by the reciprocal of the dielectric loss. Therefore, to achieve a high resonance Q-value, it is preferable to make the dielectric loss as small as possible. The dielectric loss expressed by the conductance $G_d$ includes all energy losses due to various causes.

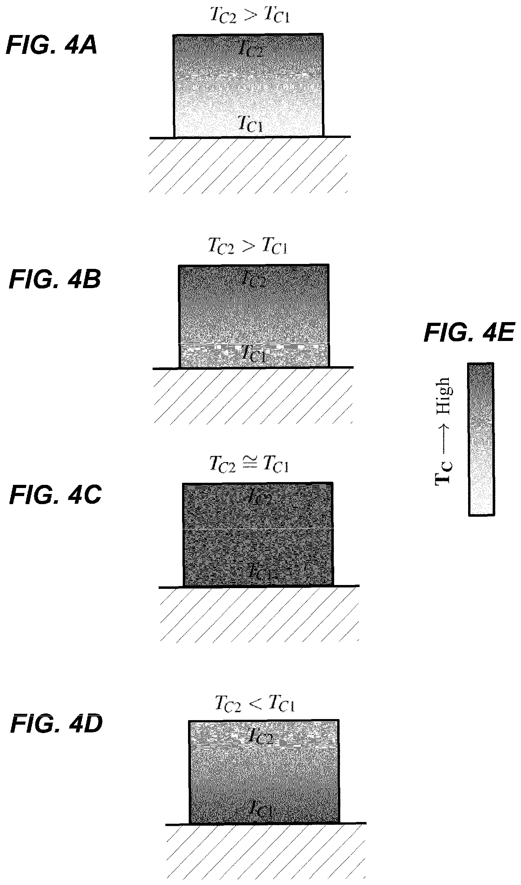

In addition, regarding the second point above, in the superconducting thin films 94 and 95, the properties of the superconductor may deviate from the ideal or bulk material properties in a position close to the interface with the dielectric 99A (for example, in the part 94a of the superconducting thin film) within the finite thickness. FIGS. 4A-E are explanatory diagrams illustrating the concept of differences in superconducting transition temperature in various parts over the thickness direction of a superconducting thin film, and are cross-sectional diagrams (FIGS. 4A-D) cutting through the thickness of the deposited superconducting thin film and a legend (FIG. 4E) of the scale of superconducting transition temperature applied to those cross-sectional diagrams. In FIGS. 4A-D, $T_{C1}$ and $T_{C2}$ indicate the local superconducting transition temperatures of the portions of the superconducting thin film that are formed at the beginning and end of the deposition process, respectively. The deviations mentioned above can be reflected in the fact that, when deposited, the superconducting material may react chemically with the substrate material, or, in the case of a compound superconducting material, the composition may be unstable, or the density of the deposited superconducting material may vary from that of the bulk material. For example, as shown in FIG. 4A, in general superconducting thin films that are formed by sputtering or vapor deposition, the quality of the film is insufficient near the substrate, and it becomes difficult to transition to superconductivity. This manifests itself as a decrease in the superconducting transition temperature $T_{C1}$. In this way, in the places where the electric field lines are close to the superconductor in the dielectric 99A, the high-frequency signals propagating through the superconductor thin films 94 and 95 suffer dielectric loss, and the performance of the superconducting resonator deviates from the ideal. In the superconductor thin film 94, which is used in direct contact with the dielectric 99A that served as the support substrate during deposition, the problem is the dielectric loss and the deviation in superconducting performance. In addition, similar losses occur when there is residual dielectric on the surface when forming the superconducting thin films 94 and 95.

As shown in FIGS. 2A and 2B, superconducting resonator devices with a structure similar to that of MSL902 and CPW903 have yet to reach sufficient performance. For example, if a superconducting thin film deposited by any method such as sputtering is used in the structure of a conventional MSL or CPW, the superconducting performance that can be expected from a bulk material of the same temperature cannot be obtained. Even in CPW, the superconducting performance deviates from the ideal performance in the finite thickness of the superconducting thin film near the interface with the dielectric (for example, in the part 96a of the superconducting thin film). The performance of the superconducting resonator deviates from the ideal because the high-frequency signal propagating on the CPW is subject to dielectric loss at the location where the electric field lines between the superconducting line 96 and the shield electrode 97 are on the dielectric substrate 99B. Even in the MKID 901 shown in FIG. 1A, the feed line 91 and resonator 92 are partially in a CPW structure with the GND electrode 93, so the performance of the superconducting resonator is not ideal at locations where the electric field lines are close to the substrate interface.

The inventors have concluded that this is the reason the resonance Q-value of conventional MKID elements has reached a plateau at around 1 million. These circumstances are also the same for elements other than MKIDs that use the resonance performance of the superconducting state, such as circuits for superconducting quantum bits, and similar circumstances are also found in superconducting resonator elements in which each part is a superconducting transmission line and a similar electrical arrangement is performed.

The inventors revised the structure of the superconductive passive element based on the assumption that, when considering the parts of the deposited superconductor over the thickness direction, the parts at the beginning of the deposition are easily affected by the substrate, and in such parts, the electric field generated between a pair of superconductive conductor parts is also easily affected. As a result, we thought that if the superconductors that make up the two conductor parts were arranged so that their outermost surfaces face each other, the superconducting properties would be recovered to their original performance, and the overal performance of the superconductive passive element would also be enhanced. We would utilize position where superconducting transition temperature $T_{C2}$ is achieved at the end of the deposition process, where the film quality tends to be high, rather than the position close to the substrate where superconducting transition temperature $T_{C1}$ tends to be low, as shown in FIG. 4A. This is the concept of the present disclosure.

2-2. Superconducting Properties of Epitaxial Growth Films

The above explanation applies to films formed by sputtering or deposition, so it is valid for many superconducting thin films. However, if the method of growing the superconducting thin film is epitaxial growth, such as MOVPE (metal-organic vapor phase epitaxy) or ALE (atomic layer epitaxy), the situation is somewhat different. FIGS. 4B-4D show simplified examples of the quality of epitaxial superconducting thin films. For epitaxial growth, a crystalline substrate that is as lattice-matched as possible to the superconductor to be formed is used, and heteroepitaxial growth is carried out on the template substrate through lattice matching. Superconducting thin films grow on the surface of the substrate with lattice matching at the atomic level, but when epitaxial growth is used, the influence of the hetero-interface of the substrate interface often becomes apparent in the initial stages of growth. In such cases, as shown in FIG. 4B, the superconducting transition temperature $T_{C1}$ in the initial stages of film formation is low, and as growth progresses, the superconducting transition temperature $T_{C2}$ approaches the value of the bulk material. This situation is not quite different from FIG. 4A, so the above second and third findings can be applied in the same way as for superconducting thin films deposited by evaporation or sputtering. However, in cases where the lattice matching with the substrate is extremely appropriate and good growth conditions are found through epitaxial growth, the effects of the heterointerface may not be so apparent. In such cases, as shown in FIG. 4C, the superconducting transition temperature of the superconducting thin film may be close to that of the bulk material throughout, from the initial superconducting transition temperature $T_{C1}$ to the final superconducting transition temperature $T_{C2}$. Furthermore, in epitaxial growth, the number of crystal transitions may increase as the film grows. In such cases, even if good film quality is obtained in the initial stage of growth, it will deteriorate as the growth progresses. In this case, as shown in FIG. 4D, the superconducting transition temperature $T_{C1}$ at the beginning of the film deposition is high, but the superconducting transition temperature $T_{C2}$ at the end of the film deposition is rather low. Therefore, in the case of epitaxial growth as shown in FIG. 4C or FIG. 4D, the above-mentioned second and third findings may not necessarily be useful. Nevertheless, it should be noted that the first finding can be used.

2-3. Structural Overview

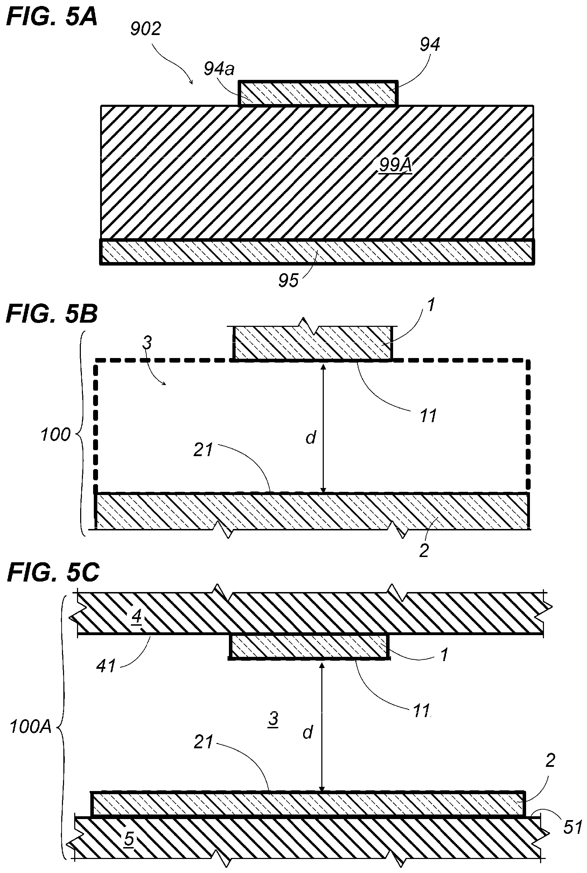

FIGS. 5A-C are schematic cross-sectional diagrams illustrating the structure of a conventional MSL (FIG. 5A) and the cross-sectional structure of superconductive passive elements 100 and 100A (FIGS. 5B and C), which are typical of the superconductive passive elements of this disclosure. The conventional MSL902 is the same as that shown in FIG. 2A, and superconductors 94 and 95, which serve as electrodes, are arranged on both sides of the dielectric 99A. The dielectric 99A serves as a support substrate during the deposition of the superconductors 94 and 95, and the superconductors 94 and 95 remain attached to the dielectric 99A after they are deposited. The superconductors 94 and 95 are superconductors such as Nb. In dielectric material 99A, through which the electric flux lines of superconductors with finite thickness 94, 95 pass, the superconductors cannot exhibit the superconducting performance that they can exhibit in bulk. In contrast, in the superconductive passive element 100 of the present disclosure, the first conductor part 1 and the second conductor part 2, which are formed by any method from a bulk material, are arranged in a manner in which the outermost surfaces 11 and 21 of the superconductors face each other. The space 3 between the first conductor part 1 and the second conductor part 2 is separated by a distance d (FIG. 5B), and the space 3 is typically maintained as a vacuum. The range of space 3 is indicated by the broken line as a typical range, but it is not particularly limited. When the structure of the superconductive passive element 100 is viewed in a cross-section where the superconductive transmission line structure crosses, it has a laminated structure in the order of the first conductor part 1, the space 3, and the second conductor part 2, and the first conductor part 1 and the second conductor part 2 are separated with the outermost surfaces 11 and 21 of the respective superconductors facing each other. In the superconductive passive element 100 of this disclosure, the parts near the outermost surfaces 11, 21 of the superconductors contained in the first conductor part 1 and second conductor part 2 are not affected by the deposition of the superconductor. This is because the superconductors of the first conductor part 1 and the second conductor part 2 are formed from bulk materials and have not undergone the deposition process. For this reason, the outermost surfaces 11, 21 of the superconductors can be expected to exhibit the original performance of the superconductor.

In the present embodiment, a superconductor formed by deposition can also be used. In that case, a structure such as the superconductive passive element 100A (FIG. 5C) is used. In a typical structure, the superconductors of the first conductor part 1 and the second conductor part 2 of the superconductive passive element 100A are deposited on the respective surfaces 41 and 51 of the first substrate 4 and the second substrate 5, which serve as support substrates, and are patterned as necessary. In other words, the superconductor of one of the first conductor part 1 is deposited on the surface 41 of the first substrate 4, and is patterned into a predetermined flat pattern shape while still attached to the first substrate 1. The term "deposition" is also referred to as "film formation" and refers to any process that involves placing a substance on the surface of a support substrate using any method and increasing its thickness. The term "thin film" refers to a film or layer structure with no particular restriction to the thickness. The superconductor of the other conductor part 2 is deposited on the surface 51 of the second substrate 5 and patterned into a predetermined planar pattern shape while still attached to the second substrate 5. After that, the first substrate 4 and the second substrate 5 are fixed to each other with the outermost surfaces 11 and 12 of the first conductor part 1 and the second conductor part 2 facing each other. The method of fixing the first substrate 4 and the second substrate 5 to each other is anything that allows the first conductor part 1 and the second conductor part 2 to be stably maintained in a configuration where they are not short-circuited with each other and are separated from each other. When the structure of the superconductive passive element 100A is viewed in a cross-section where the superconductive transmission line crosses, it has a laminated structure in the order of the first substrate 4, the first conductor part 1, the air gap 3, the second conductor part 2, and the second substrate 5, and the first conductor part 1 and the second conductor part 2 are separated with the outermost surfaces 11 and 21 of the respective superconductors facing each other. In the structure of the superconductive passive element 100A, even if the superconductors of the first conductor part 1 and second conductor part 2 do not show the expected superconductive properties in the portions that are in contact with the supporting substrate, the outermost surfaces 11 and 21 are not greatly affected by the deposition. Therefore, the performance of the superconductive passive element 100A is not easily affected by the adverse effects of the superconductor deposition. This is because the superconductors of the first conductor part 1 and the second conductor part 2 can exhibit sufficient performance in the portions close to the outermost surfaces 11 and 21 at the time of deposition. The superconductive passive element 100A is one typical example of performing the embodiment of the present disclosure by using multiple substrates.

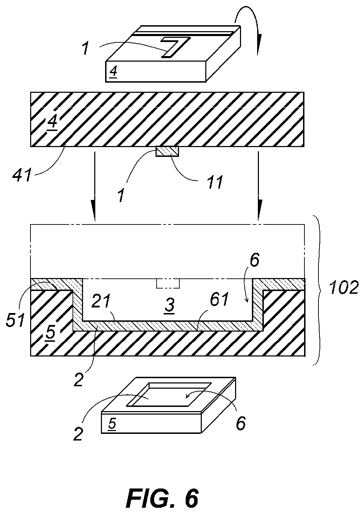

FIG. 6 is a cross-sectional view showing a schematic of another typical example of the present disclosure, a superconductive passive element 102, as shown in FIG. 5C. In the superconductive passive element 102, the first conductor part 1 and the second conductor part 2 are arranged so that the outermost surfaces 11 and 12 of the superconductors contained therein face each other. The superconductive passive element 102 is a superconductive passive element 100A (FIG. 5C) with a recess 6 formed in the second substrate 5. The superconductive material for the second conductor part 2 is deposited on the part 61 of the inner surface of the recess 6 that faces the surface on which the first conductor part 11 of the first substrate 4 is deposited. After that, if the first substrate 4 and the second substrate 5 are bonded together, the first conductor part 1 and the second conductor part 2 can be fixed while maintaining the outermost surfaces 11 and 21 of the respective superconductors facing each other while being separated. The distance d (FIGS. 5B and 5C) between the first conductor part 1 and the second conductor part 2 in the air gap 3 is typically set to a distance of 0.1 to 100 $\mu$m, and the air gap is typically a vacuum, or in another typical case, a gas (including air) that does not affect the dielectric properties. In order to arrange the first conductor part 1 and the second conductor part 2 in the superconductive passive element 100A as described above, it is not necessary to form a recess 6 such as in the superconductive passive element 102, and any means that can fix the first substrate 4 and the second substrate 5 with respect to each other can be employed.

The superconductive passive element 102 proposed in the present embodiment can be structured so that the first conductor part 1 and second conductor part 2 form a microstrip line structure, for example when applied to a superconducting resonator. In the case of a superconducting resonator using the superconductive passive element 102 proposed in the present embodiment, if it has an inductor and a capacitor with a meander structure (neither of which is shown in the figure), at least one of the first conductor part 1 or the second conductor part 2 can be structured to form said inductor and capacitor.

When an MKID is fabricated using a superconductive passive element with the above structure and operated, it was confirmed that a resonance Q value that is an order of magnitude larger than that achieved with conventional superconductive resonator elements can be obtained (described later in the Examples).

2-4. Manufacturing Process

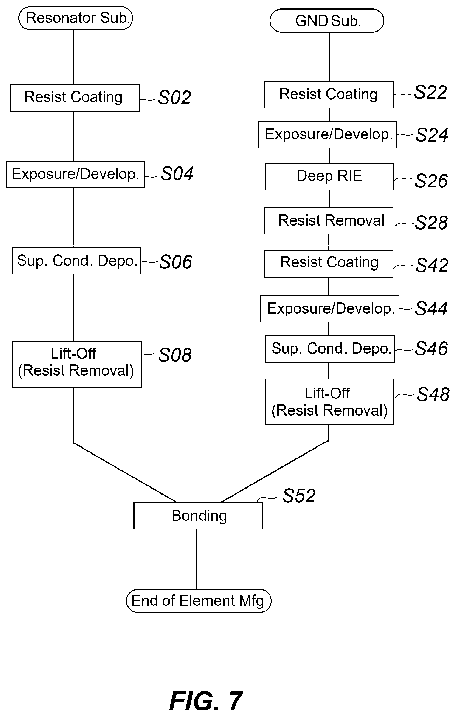

Next, we will explain the manufacturing process for the superconductive passive element in the embodiment of the present disclosure. FIG. 7 is a flowchart showing the manufacturing process for a sample of the superconductive passive element in the embodiment of the present disclosure. As an example, we will explain the case of manufacturing an MKID using the superconductive passive element 102 shown in FIG. 6, and will continue to refer to the symbols used in the explanation of FIGS. 5C and 6. The manufacturing method (S02 to S52) for the superconductive passive element in this example is divided into roughly three stages. The first comprises the steps (S02 to S08) for manufacturing the first substrate 4 with the first conductor part 1 formed on it (referred to as the "resonator substrate"). The second comprises the steps (S22 to S48) for fabricating a second substrate with a second conductor part formed on it as a GND electrode ("GND substrate"). The third comprises the bonding step (S52) for bonding and fixing the resonator substrate and the GND substrate together.

In the stage for fabricating the resonator substrate, photoresist is applied to the surface 41 of an appropriate first substrate 4 (e.g., a single-crystal silicon wafer) (S02), and exposure through a photomask and development are carried out to form the desired resist pattern (S04). Next, a superconductor such as Nb is deposited on the surface 41 where the desired pattern has been formed by the resist (S06). The deposition method is not particularly limited, but existing deposition methods such as sputtering using argon gas are used. In some cases, a vapor deposition method is used, depending on the material of the superconductor. In addition, an epitaxial growth method is used by adopting a crystalline substrate as the first substrate 4. The specific thickness of the superconductor to be deposited is set to a thickness sufficient to achieve a sufficiently high resonance Q value for the superconductive passive element 102 (MKID) after fabrication. In other words, by forming a sufficiently thick superconductor in the superconductive passive element after fabrication, it is possible to perform superconductive performance that is not affected by the surface 41 of the first substrate 4. This is followed by the lift-off step (S08). In other words, by removing the resist that remains partially under the deposited superconducting thin film, the pattern is formed so that the part of the deposited superconducting thin film that is directly deposited on the surface 41 is remained. In this way, the pattern of the first conductor part 1 is formed and the resonator substrate is completed.

The process of fabricating the GND substrate can be divided into two stages: the stage of forming the recesses (steps S22 to S28), and the subsequent stage of depositing and patterning the superconductor for the second conductor part (steps S42 to S48). The recesses are formed by applying photoresist to an appropriate second substrate 5 (e.g. a single-crystal silicon wafer) (step S22), and then exposing and developing it to form the desired resist pattern (step S24). After the deep reactive-ion etching (Deep RIE) step to form the recess 6 on the surface 51 of the second substrate 5 on which the resist pattern has been formed (S26), the resist is stripped (S28). The depth of the recess 6 can be determined as appropriate so that the distance d (FIG. 5B) between the first conductor part 1 and the second conductor part 2 is appropriate. After that, the same step as the formation of the resonator substrate is followed, including resist coating (S42), exposure/development (S44), superconductor deposition (S46), and lift-off (S48). In this way, the GND substrate is completed by obtaining the second conductor part 2 with the superconductor formed in the desired pattern.

In the lamination step (S52), the resonator substrate and the GND substrate are fixed to each other so that the outermost surfaces 11 and 21 of the superconductors for the first conductor part 1 and the second conductor part 2, respectively, are arranged to face each other when they are deposited on top of each other. In this case, the resonator substrate and the GND substrate are aligned with each other as necessary. After the lamination step, the MKID using the superconductive passive element 102 is completed. Once the MKID is complete, any necessary ancillary processes such as connection processing to establish electrical connections with the outside for measurement and operation are carried out. The completed MKID can then be operated by cooling it to the required temperature.

The manufacturing process described above is not particularly difficult for those skilled in the art to implement, and does not require any chemicals that require careful handling. In addition, if the first conductor part 1 and the second conductor part 2 both use bulk material superconductors, the stage of forming a patterned first conductor part 1 from bulk material are used in place of steps S02 to S08, the steps of forming a patterned second conductor part 2 from bulk material are used in place of steps S22 to S48, and the lamination step (S52) is used.

2-5. Demonstration of Performance by Example

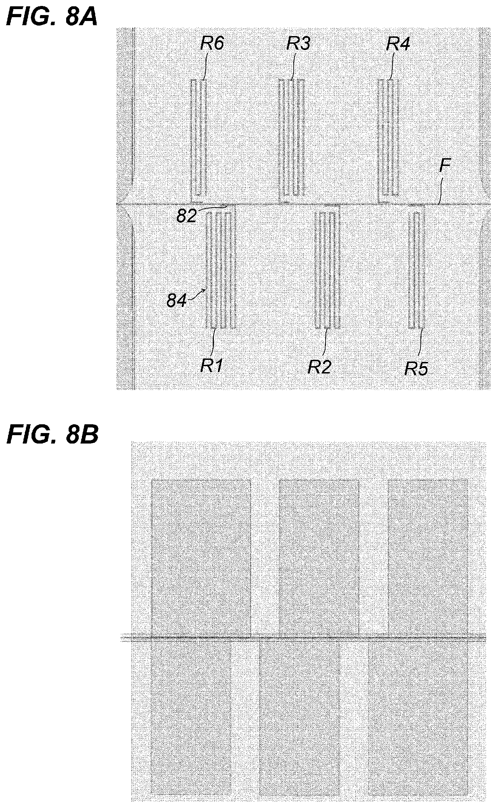

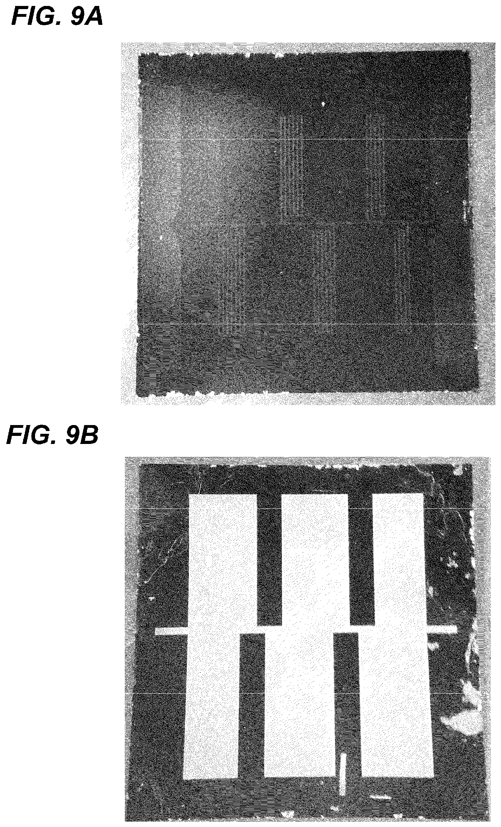

As an example of the superconductive passive element 102 of this disclosure, an example sample of the MKID with the cross-sectional structure shown in FIG. 6 was fabricated in accordance with the manufacturing method shown in FIG. 7. FIGS. 8A and 8B show the design of the photomask for exposure to lift off the superconductive thin film of the resonator substrate and the GND substrate, respectively. FIGS. 9A and 9B are optical photographs of the resonator substrate and the GND substrate after patterning, respectively. As can be seen in FIGS. 8A and 9A, the sample of the present invention has six resonators R1-R6 (FIG. 8A) with different resonance frequencies, and each of the resonators R1-R6 is coupled to a single feed line F extending from the center of the resonator to the left and right of the picture plane. As shown in resonator R1 in FIG. 8A, each of the resonators R1 to R6 has a coupling section 82 that is parallel to the feed line F and is not directly conductive, but is AC coupled, and a resonance section 84 that extends perpendicularly to the feed line (up and down on the picture plane) from the coupling section and meanders back and forth for the necessary length. The longer the total length of the resonator 84, the lower its resonance frequency. In the optical photomicrographs in FIGS. 9A and 9B, the bright and dark areas respectively indicate the exposed outermost surface of the Nb deposition and the surface of the single-crystal silicon wafer. The resonators R1 to R6 are named in order of decreasing resonance frequency design value.

Table 1 shows the resonance frequencies of each resonator from R1 to R6. Note that each value is a design value that includes the effect of AC coupling.

[Table 1]

| Resonator | Resonant Freq. (Designed Value) [GHz] | Resonator | Resonant Freq. (Designed Value) [GHz] |
|---|---|---|---|
| R1 | 4.10 | R4 | 5.53 |
| R2 | 4.68 | R5 | 6.66 |
| R3 | 4.72 | R6 | 6.73 |

The details of the other design conditions are as follows. The chip size was 10 mm square, the depth of the recess was 10 $\mu$m, the thickness of the superconductor (Nb) for the first conductor part 1 and second conductor part 2 was 0.2 $\mu$m, the line width of the resonators R1 to R6 was 24 $\mu$m, and the distance d (FIG. 5B) of the air gap 3 was 12 $\mu$m. A path allowing air to flow between the air gap 3 and the outside world was secured, where the air gap 3 would become vacuum when the atmosphere of the MKID is made vacuum.

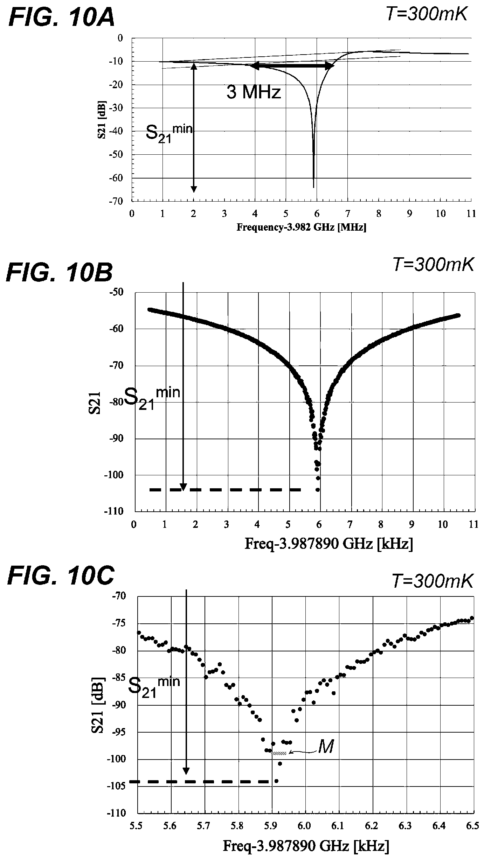

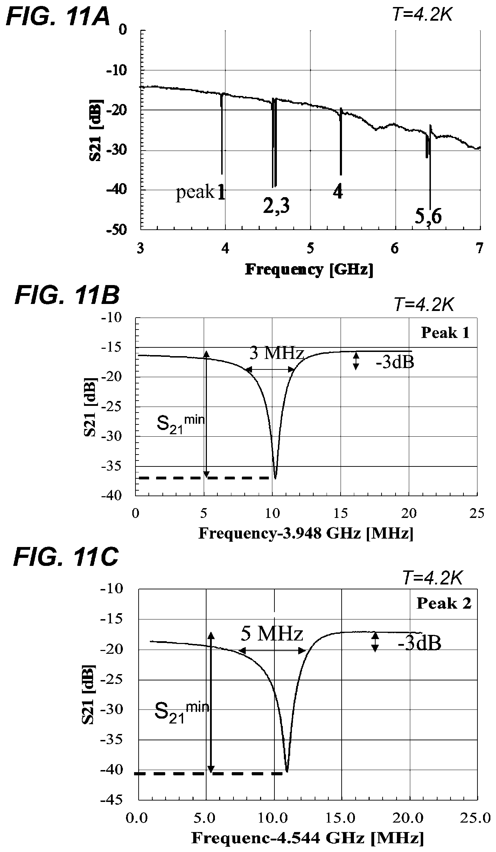

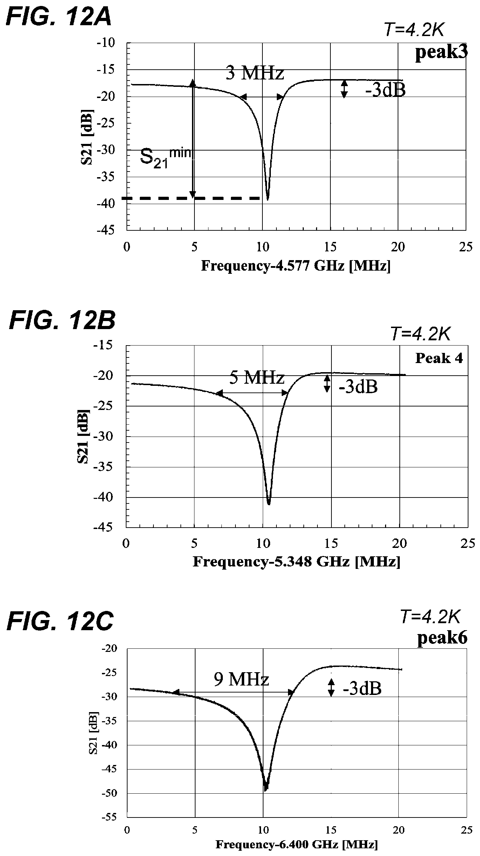

FIGS. 10A-C are graphs indicating the measured characteristics of the resonance dip of the MKID, which is a sample of the superconducting resonator element of this disclosure, when cooled to 300 mK. FIGS. 10A-C are graphs displaying the frequency range around the dip obtained at R1, in accordance with the design values shown in Table 1, with the frequency range expanded. This characteristic is the result of supplying high-frequency power for reference to one end of the feed line and obtaining a detection signal from the other end, and calculating and displaying the spectrum of the S parameter transmission coefficient $S_{21}$ in logarithmic (dB) scale. In addition, FIGS. 11A-C and FIGS. 12A-C are spectra of similar transmission coefficient $S_{21}$ obtained near the resonance frequency of each resonator of the sample in the liquid helium temperature (4.2 K). In all measurements, the sample was placed in a cryostat that was free from external electromagnetic waves and maintained a vacuum state. The measurements were conducted on a sample in which the superconducting resonator element of the present disclosure was applied to the MKID, and the resonance Q value could be observed at each temperature. This resonance Q value is an indicator of the soundness of the superconducting state of the first conductor part 1 and the second conductor part 2.

As shown in FIGS. 10A-C, the internal resonance Q-value $Q_i$ of the resonator in a 300 mK temperature environment was approximately $10^8$, which is an unprecedentedly high value. Looking into the details, FIG. 10A shows the transmission coefficient $S_{21}$ over a frequency range (11 MHz width). As shown in FIG. 10A, the half-width (full-width at half maximum) $\Delta f$ of the entire resonance dip, which gives a value 3 dB lower than the baseline -10 dB line, was 3 MHz. From this, the resonance Q value Qc, which includes the effect of AC coupling, was calculated to be

$$Q_c \sim 3.959 \text{ GHz}/3 \text{ MHz} \sim 1,300. \quad (1)$$

The resonance showed an extremely sharp and deep dip, so we obtained data with sufficient frequency resolution to accurately determine the value of the transmission coefficient $S_{21}$. As shown in the enlarged views in FIGS. 10B and 10C, the minimum value of the drop in the transmission coefficient $S_{21}$ from the baseline ($S_{21}^{min}$) was less than -90 dB. Calculating the internal Q value $Q_i$ from this value,

$$Q_i = Q_c / S_{21}^{min} \sim 1,300 \times 10^{4.5} \sim 4.1 \times 10^7, \quad (2)$$

and it was confirmed that a high internal resonance Q value of $Q_i$ of around $10^8$ was being performed. In addition, the $Q_i$ value estimated from the value 6dB (double the power) from the peak of the resonant structure is around 40Hz from the width of the mark M shown by the hatching in FIG. 10C, and the $Q_i$ value obtained from this is $Q_i \sim 10^8$, and it is reconfirmed that $Q_i \sim 10^8$ is also obtained using this calculation method.

In measuring the internal resonance Q value $Q_i$, a tiny transmission coefficient $S_{21}$ of around -90dB is determined and a reliable resonance Q value of the order of $10^8$ is obtained, but this measurement is not easy. To perform this measurement by using a commercially available vector network analyzer capable of measuring resonance Q values of around $10^7$, first, the power supply environment is stabilized. Furthermore, external noise is strictly blocked. To minimize the effects of the earth's magnetic field, a magnetic shield is placed near the resonator. Since it is not possible to measure resonance at -90dB at once, the measurement bandwidth is divided into multiple sections, including the entire resonance profile, the vicinity of the resonance frequency, and the very vicinity of the resonance frequency. In addition, in order to stabilize the frequency, it is necessary to suppress phase noise, and a low-temperature low-noise amplifier (Cryogenic LNA, CITCRYO 1-12, Cosmic Microwave Technology, Inc., Lone Dale, California, USA; noise temperature: 10 K or less) is used. To improve the signal-to-noise ratio (S/N ratio) and reduce the noise floor, the measurement power, measurement points, I.F. bandwidth, etc. are optimized, and the number of integrations is increased by performing measurements over a long period of time. With these measures, it is possible to measure a resonance Q value of around $10^{12}$ as a reliable value. In the above confirmation, the electromagnetic shielding effect of the cryostat for cooling was utilized. In this situation, we used a vector network analyzer (PNA5221A, Keysight Technology, Santa Rosa, California, USA; dynamic range 127 dB) to perform multiple measurements, each of which took more than 12 hours and involved around 3500 integrations, and we were able to determine the minute transmission coefficient $S_{21}$ of around -90 dB by adopting the data from the measurement rounds that were unaffected by power supply fluctuations, etc.

Considering that the internal resonance Q-value $Q_i$ of conventional resonators using MSL or CPW was around several hundred thousand at a temperature of around 100 mK, the results in FIGS. 10A-C, where the internal resonance Q-value $Q_i$ was around $10^8$ at a temperature of 300 mK, show that the present inventors' insight was correct. These results are also consistent with the fact that one of the factors limiting the performance of conventional superconducting resonators was the residual effects of the deposition process on the superconductor.

FIGS. 11A-C and 12A-C are spectra of the transmission coefficient $S_{21}$ measured by the MKID of the example sample at a liquid helium temperature (4.2 K). FIG. 11A covers the measured frequency range. In the spectrum of the transmission coefficient $S_{21}$, which decreases generally as the frequency increases, six dips are clearly observed, and the second and third dips, as well as the fifth and sixth dips, are close to each other. The frequencies of the first to sixth dip, from the lowest to the highest, are those of resonators R1 to R6, whose resonance frequencies are shown in Table 1, and are distinguished as peak 1 to 6 in order of decreasing frequency. For example, peak 1 is that of resonator R1.

FIGS. 11B-C and 12A-C show the spectra of the transmission coefficient $S_{21}$ in the frequency range (25 MHz width) around peaks 1-4 and peak 6. Peaks 1-4 and peak 6 are, in order, the resonance dips of resonators R1-R4 and R6 in FIG. 8A. The internal resonance Q values $Q_i$ at each frequency calculated in the same way as Equations (1) to (2) for these dips are shown in Table 2.

[Table 2]

| FIG | Resonator (FIG. 6A) | $Q_i$ | FIG | Resonator (FIG. 6A) | $Q_i$ |
|---|---|---|---|---|---|
| 9B | R1 | 15,000 | 10B | R4 | 13,000 |
| 9C | R2 | 13,000 | 10C | R6 | 10,000 |
| 10A | R3 | 19,000 | | | |

Thus, it was confirmed that the MKID of the present sample achieved internal resonance Q values $Q_i$ of around 10,000 to 19,000 at a liquid helium temperature (4.2 K) where resonance could not be obtained with conventional devices.

The fact that the MKID in the example sample performs resonance at a liquid helium temperature at which resonance cannot be confirmed with conventional MKIDs constitutes unmistakable evidence of the high practicality of superconducting resonators, which are one form of superconductive passive element described in this disclosure. Superconductive passive elements that include the new superconducting transmission lines provided in this disclosure can also demonstrate high practicality even if they are not MKIDs.

Furthermore, the MKID in the example can be said to have high practicality even when viewed as the operation of a resonator that uses superconductivity. This is because it is possible to achieve an internal resonance Q value $Q_i$ that approaches that of a cavity resonator on a chip that is smaller than conventional cavity resonators and has potential for practical use.

Based on the facts confirmed by the MKID of the above example samples, the findings of the present embodiment can be summarized as follows:

~ In conventional superconducting resonator elements in which Nb was formed as a superconductor in a dielectric or substrate, losses occurred at the positions where the electric lines of force in the superconductor (substrate) passed through.

~ By adopting the structure of the superconductive passive element of the present disclosure, it is possible to greatly reduce the losses of the superconducting resonator element.

~ In the MKID sample using Nb and the structure of the superconductive passive element disclosed herein, a high internal resonance Q value of $Q_i$ of approximately $1.3 \times 10^8$ can be performed with a measured value of approximately 300 mK.

In the same MKID, resonance operation, which previously required cooling to around 100 mK and was difficult to observe in a liquid helium temperature (4.2 K) environment, was confirmed at a liquid helium temperature, and the internal resonance Q value $Q_i$ reached around 10,000.

2-6. Potential Performance

We will now explain the performance of the superconductive passive element in the present embodiment, including its temperature characteristics, as confirmed by the superconductive resonator element in the example. We will first explain the operation of the MKID, and then also explain the operation of the superconductive passive element other than the MKID.

It is known that the theoretical formula for the number of residual quasiparticles $n_{th}(T)$ due to thermal excitation is given by Formula (3A). $N_0$ is the density of states per unit energy on the Fermi surface of electrons, $k_B$ is the Boltzmann constant, T is the absolute temperature, and $\Delta(T)$ is the superconducting gap.

[Math 9]

$$n_{th}(T) \propto N_0 \sqrt{2\pi\Delta(T)k_B T} \exp\left\{-\frac{\Delta(T)}{k_B T}\right\} \qquad (3A)$$

$$Q_i^{-1} \propto n_{th}(T) \qquad (3B)$$

The internal resonant Q-value $Q_i$ of the superconductor in the MKID obtained in the sample of the present disclosure is theoretically linked to the right-hand side of Formula 3A via Formula 3B. The temperature dependence of the resonant Q-value of the MKID having the characteristics of the superconductive passive element of the present disclosure is expected to behave in accordance with the theoretical value, i.e., Formula (3A). In other words, it can be expected that the MKID with the characteristics of a superconductive passive element in the present embodiment will have lower losses and an exponentially improved resonance Q-value when cooled, even in the low-temperature region below 1 K, compared to conventional MKIDs. By applying this to the performance at 4.2 K shown in FIGS. 11A-C, 12A-C, and Table 2, it is possible to predict the resonance Q-value in a temperature environment of around 2 K, which can be rather easily achieved using a mechanical refrigerator. Specifically, it is predicted that a resonance Q value of around 300 times that of 4.2 K (~3,000,000) can be achieved at 1.5 K. This value exceeds the resonance Q value of the most advanced conventional MKID, and exceeds the Q value of 1,000,000, which is the benchmark for practical use of MKIDs. Therefore, in the MKID of the example sample of this disclosure, a simpler, lower-cost mechanical refrigerator can be used instead of a dilution refrigerator to perform well even at a temperature of around 1.5 K. The example sample of this disclosure can relax the restriction on the inflow of heat into the space where the MKID is placed, and also reduce the facilities and labor required to maintain the cooling state.

3. Application examples/modified examples

The good superconductive performance suggested by the high internal resonance Q value $Q_i$ obtained with the MKID sample in this disclosure can be said to improve the performance of various superconductive passive elements, and so has a potentially extremely wide range of applications. Here, we will explain applications based on superconductivity.

3-1. Superconducting Quantum Computer

As mentioned above, the structure of the superconductive passive element in the present embodiment has been adopted for a superconducting resonator that uses mechanical inductance, and it has been confirmed experimentally that an unprecedentedly high resonance Q value has been achieved. The superconductor of this superconducting resonator is in a good superconducting state, as is the case with bulk materials, and this means that the ratio of electrons that are in a Cooper pair in the superconducting state is high. This indicates that the superconducting state of the superconductor is ideal in the superconducting transmission lines that make up the superconducting resonator, and that the effects of disturbing factors for the superconductor, such as the substrate, have been successfully eliminated. Such ideal operation can also be expected in any superconductive passive element that uses the same superconducting transmission lines as its components.

In a superconducting quantum computer that uses a circuit for superconducting qubits with a superconducting resonator, the time available for a single quantum calculation is proportional to the time the quantum state is maintained. For example, if a 100-fold increase in the resonance Q value and a 100-fold increase in the time the quantum state is maintained can be achieved, the time available for a single quantum calculation, which is currently around 100 $\mu$s, can be increased by a factor of 100. If this improvement can be achieved by adopting the structure of the superconductive passive element in the present embodiment, it is expected that more complex calculations and larger-scale quantum circuits than before will be realized, leading to the innovative development and strong promotion of the industrialization of superconductive quantum computers.

On the other hand, even if the resonance Q value is only at the same level as that of the current state-of-the-art superconducting quantum computer, the performance of the superconductive passive element of the present disclosure provides high practicality. This is because the performance that previously required cooling to 100 mK can be achieved in an environment with a temperature of around 1.5 K, making it easier to create an environment for high-performance superconducting quantum computers. This type of mechanical refrigerator is available on the market and can be combined with pulse tube (PT) refrigerators or GM refrigerators. In addition, refrigerators with cooling power in watt-class are available at low cost. Therefore, the fact that a dilution refrigerator is not required and a temperature of 1.5 K is sufficient, compared to the 100 mK required for a dilution refrigerator, greatly contributes to the improvement of practicality.

In addition to superconducting resonators, the superconductive passive elements described in the present disclosure are also expected to be used in parametric amplifiers, which are preamplifiers for signal readout in superconducting quantum computers.

3-2. Superconducting Transmission Line

One application for which the structure of the superconductive passive element disclosed herein can be applied, in addition to resonators, is superconducting transmission lines, which are expected to have the ability to transmit power and signals in a superconducting state, such as superconducting currents. More specifically, the structure of the superconductive passive element disclosed herein can be used to create ultra-high frequency, low-loss transmission lines and high-performance superconducting circuits. The reciprocal of the resonance Q-value expresses the ratio of the loss generated by the signal traveling back and forth within the resonator. For example, the fact that the resonance Q-value is around $10^8$ with the current design (resonator length of around 20 mm) is equivalent to the signal propagation distance reaching 2,000 km. This means that if the Q value, or the number of vibrations that can be repeated in the resonator, is $\sim 10^5$, and the propagation distance is expressed as $L_Q$, then the value is $L_Q \sim 20\,mm \times 10^5$, or 2km. If the same value is calculated as $Q \sim 10^8$, the value becomes $L_Q \sim 2,000\,km$. Considering that the total wiring length of a normal LSI is about 10m, this loss is a level that does not need to be considered in the structure of a superconducting circuit.

In addition, the superconductive passive elements of the present disclosure are also useful as superconductive transmission lines that transmit high-frequency power. The superconductor Nb, which is mentioned in the present disclosure, has a superconductive transition temperature of 9 K and a gap frequency equivalent to approximately 700 GHz. Therefore, if high-frequency performance is realized, it is expected that a terahertz superconductive computer that operates at terahertz frequencies in the range of several hundred GHz will be possible.

3-3. Ultra-high Frequency Low-loss Filters / Terahertz Spectrometers Using Superconducting Resonator Filters in the Terahertz Band

By adopting the structure of the superconductive passive element described in this disclosure, it is possible to perform the high-frequency drive described in 3-2, and to perform high-performance superconducting filters in the terahertz band. Such filters can be used as high-Q filters, which are essential for terahertz signal transmission, which is expected to be used for ultrahigh-speed wireless communication in Beyond 5G/6G. Such filters can also be used for radio astronomy spectroscopy, and can be used as a simple spectroscopic method that replaces conventional heterodyne detection. In the past, heterodyne detection using SIS mixers has often been used for radio astronomy spectroscopy. However, another terahertz light source called a local oscillator (LO) is required, and the difference frequency with this light source is used, and the bandwidth is narrow, making it difficult to create an array. In contrast, a spectroscopic method using a filter has been performed by Endo et al. of the Delft University of Technology (Non-Patent Document 4). With conventional detectors, there is a problem that the signal transmission loss is large, and the frequency resolution cannot be made high because the resonance Q value cannot be made high. In contrast, the filter that uses the structure of the superconductive passive element disclosed in this document can dramatically reduce the signal transmission loss and achieve a high resonance Q value, which in turn allows a high frequency resolution and dramatically improves the spectral performance. The LO light source is not required for this operation, and a very wide bandwidth can be achieved. In addition, it is easy to make an array, and the sensitivity to narrow linewidth bright lines is dramatically improved, making it possible to search for distant galaxies and to observe faint celestial objects over a wide area with high sensitivity.

3-4. Improving the Sensitivity of Superconducting Kinetic Inductance Detectors )

Superconducting Kinetic Inductance Detectors (KIDs) are next-generation detectors that combine superconducting resonators and energy input devices (such as antennas) to achieve both high sensitivity and large-scale arrays. The detection sensitivity is determined by the capacitance (electrostatic capacity) and electrical and mechanical inductance within the device, and the higher the resonance Q value, the higher the sensitivity. Therefore, it is possible to dramatically improve the detection sensitivity by fabricating a detection device that uses the structure of the superconductive passive element disclosed herein.

3-5. Measurement Cell for Dielectric Properties

In the explanations up to this point, we have described the air gaps (air gaps 3, FIGS. 5B and 5C) of the superconductive passive element in the present embodiment as being filled with either a vacuum or a dielectric-free gas. The reason for this is that there are few materials whose dielectric properties are known at temperatures of a few Kelvin or lower, which is a typical operating environment for superconductive passive elements, and even for the materials whose dielectric properties are known, the dielectric loss is large, such as silicon. However, the superconductive passive element in the present embodiment can also be used in applications where dielectric loss is not a problem, even if some insulating material is placed in the air gap. The problem is that there are few materials for which accurate dielectric properties have been measured at low temperatures. In such cases, for example, a superconductive resonator with the structure of the superconductive passive element in the present embodiment can be fabricated, and the test material can be mounted in the air gap to measure the transmission coefficient $S_{21}$. By comparing its performance with that of a vacuum, and using the area and distance d (FIGS. 5B and 5C) of the opposing parts of the first and second conductor parts, it is possible to determine the dielectric properties of the test substance. In this way, the superconductive passive element of the present embodiment can also be used as a measurement cell for dielectric properties.

3-6. Other Applications

In addition to the above, the superconductive passive elements of the present disclosure can be used in the following applications:

~ Realization of functional components at ultra-high frequencies and measurement technology using these components,
~ Terahertz isolators and measurement technology using these isolators,
~ Frequency combs and measurement technology using these combs,
~ Gravitational wave detection and measurement technology using these detectors,

~ Ultra-high frequency clocks and measurement technology using these clocks,

~ Ultra-high frequency and ultra-stable oscillators, and measurement technology using these,

~ High-sensitivity sensors, measurement of optical constants (by sandwiching the object), and measurement technology using these,

~ Low-noise ultra-high frequency amplifiers (up to several hundred GHz), and measurement technology using these,

~ Development for high-temperature superconductors (possibility of superconducting quantum computation at liquid nitrogen temperature), and measurement technology using these, and

~ Other high-frequency devices and equipment, including superconducting resonators.

3-7. Materials of Superconductors

The experimental results described above are achieved using Nb, but the superconducting material used for the superconductive passive element of the present embodiment can be any material that is capable of exhibiting superconductivity, and there are no restrictions. As non-limiting examples of superconducting materials that can be used, superconducting materials that are easy to deposit in thin films, such as NbN (niobium nitride), are useful for achieving the superconductive passive element of the present disclosure. If a similar effect can be achieved with another material that has a higher superconducting transition temperature ($T_c$), it is also possible to expect that a sufficiently high resonance Q value can be obtained at a higher operating temperature. For example, the superconducting transition temperature of Nb is 9.2 K, but the $T_c$ of NbTi, a material that is used typically in superconducting electromagnets, is 11.5 K, and that of MgB2 is 39 K. In addition to the above, Ta (tantalum, $T_c$ = 4.5 K), Al (aluminum, $T_c$ = 1 K), Ti (titanium, $T_c$ = 2.4 K), Hf (hafnium, $T_c$ = 165 mK), W (tungsten, $T_c$ = 16 mK), TiN (titanium nitride, $T_c$ = 5.6 K), NbTiN (niobium titanate, $T_c$ = 1 5 K) and other metal and nitride materials are useful for achieving the superconductive passive elements described in the present disclosure. In addition, although the mechanism of superconductivity is slightly different, the high-temperature superconductors have high superconducting transition temperatures $T_c$, such as 93 K (YBCO) and 133 K (HBCO) for copper oxide superconductors and 110 K (BSCCO) for bismuth-based superconductors. Since superconductivity occurs at liquid nitrogen temperatures for these materials, if a similar effect can be achieved with these materials, the cost of cooling can be reduced significantly. Furthermore, the search for materials with even higher superconducting transition temperatures is continuing, and it may be possible to perform the superconductive passive element of this disclosure at a temperature closer to room temperature.

3-8. Variations in Structure

The superconductive passive elements of the present disclosure also include variations in structure.

3-8-1. Combination of Thin-Film Superconductor and Bulk Superconductor

In the superconductive passive element of the present disclosure, it is not necessarily the case that both the first conductor part 1 and the second conductor part 2 (FIG. 5B) are superconductive thin films. In other words, the first conductor part 1 is a superconductive thin film, and the second conductor part 2, which makes a pair with it, can be a bulk superconductor. This is because, unlike thin films, bulk superconductors are not affected by the support substrate during deposition, and superior performance can be achieved in superconducting thin films by orienting the outermost surface during deposition towards the other superconductor.

3-8-2. MEMS

The present disclosure can also be applied to structures in which a superconducting thin film is used, even though the supporting substrate is not left in the final superconductive passive element, as is the case with **MEMS** (Micro Electro Mechanical Systems) technology, for example, or in structures that use a three-dimensionally constructed hierarchical structure. **In** such structures, good superconducting performance can be achieved in the superconductor that corresponds to the first conductor part 1 in FIG. 5B. Namely, the part of the superconductor corresponding to the outermost surface 11 of the superconductor corresponding to the first conductor part 1 becomes the outermost surface during deposition and faces another superconductor corresponding to the second conductor part 2, so it becomes the structure of the superconductive passive element of the present disclosure. For example, even if the superconductor corresponding to the first conductor part 1 is deposited on a support substrate and then the support substrate is removed, a good superconducting state can be performed in parts where the remaining superconductor has a bridge shape or cantilever shape that does not require other support (i.e., it is self-supporting). Even if the supporting substrate is removed, the superconductor may still retain the influence of the supporting substrate before it was removed, so as long as the outermost surface at the time of deposition is made to face the superconductor with which it forms a pair, the benefits of the superconductive passive element of the present disclosure can be enjoyed. In addition to this, if it is constructed using microfabrication technology for some kind of semiconductor integrated circuit and has the structure shown in FIG. 5B, it can function as a superconductive passive element of the present disclosure.

3-8-3. Use of Dielectric Materials

Materials whose dielectric characteristics, particularly dielectric loss (dielectric tangent, tan $\delta$), have been measured using any method, such as the measurement cell for dielectric characteristics described above, can be placed in the air gap (air gap 3, FIGS. 5B and 5C) depending on the application to which the superconductive passive element of the present embodiment is applied. The ability to place a substance in the air gap has the effect of making it easier to fix the first conductor part 1 and the second conductor part 2 to each other if the substance is a solid, and it also has the effect of increasing cooling performance if the substance is liquid helium. The dielectric loss allowed for the substance depends on the application. This is because there is a possibility that a substance that cannot be used in an application where the resonance Q value is to be increased as much as possible in a resonator can be used in a transmission line that conveys sufficient high-frequency signals if the necessary transmission performance is performed. That is, the dielectric loss of the substance to be used can be measured under realistic conditions using a measurement cell, etc., and the substance can be selected by comparing this with the prescribed value of the dielectric loss determined by the application. The discussion of the resonance Q-value, which we have explained in the case of a vacuum, is for the case where the dielectric loss is negligible and small. In the case where the dielectric loss has a finite magnitude, the reciprocal of the resonance Q-value of the resonator is given by the sum of the reciprocal of the Q-value of the resonator made of only a superconductor and the dielectric loss. If the Q-value of the resonator made of only a superconductor becomes extremely large, the Q-value of the resonator is given by the reciprocal of the dielectric loss.

4. Conclusion

The embodiments of the present disclosure were described in detail in the above. The above embodiments, variations and examples were described to explain the invention disclosed in this application, and the scope of the invention of this application should be determined based on the claims. Variations that exist within the scope of the present disclosure, including other combinations of embodiments, are also within the scope of the claims. In other words, the person skilled in the art can make various modifications, combinations, sub-combinations, and substitutions with respect to the components of the above-mentioned embodiments within the technical scope of the present invention or its equivalent.

Industrial Applicability

The present disclosure may be reduced into practice for any types of devices having a superconductive passive element in its circuitry.

Reference Signs List

| | |
|---|---|
| 100, 100A, 102 | superconductive passive element |
| 1 | first conductor part |
| 11 | outermost surface when first conductor part is deposited |
| 2 | second conductor part |
| 21 | outermost surface when first conductor part is deposited |
| 3 | gap |
| 4 | first substrate |
| 41 | surface of first substrate |
| 5 | second substrate |
| 51 | surface of second substrate |
| 6 | recess |
| 61 | inner surface of recess |
| 82 | coupling section (of resonator) |
| 84 | resonance section (of resonator) |
| R1 to R6 | resonator |

**Claims**

1. A superconductive passive element, comprising.

   a first conductor part having a superconductor, and
   a second conductor part having a superconductor,
   wherein the first conductor part is configured such that an outermost surface of the superconductor of the first conductor part is facing the second conductor part while being separated from the second conductor part.

2. The superconductive passive element according to claim 1, wherein

   the superconductor of the first conductor part is deposited, and
   the outermost surface is an outermost surface at the time of the deposition of the superconductor of the first conductor part..

3. The superconductive passive element according to claim 2, wherein

   the superconductor of the second conductor part is deposited, and
   the first conductor part and the second conductor part are configured such that the outermost surfaces of the superconductors are facing each other and are separated from each other.

4. The superconductive passive element according to any of claims 1-3, wherein the first conductor part and the second conductor part are arranged with a vacuum or a gap between them.

5. The superconductive passive element according to any of claims 1-3, wherein

   high-frequency power is supplied to the first conductor part, and
   the second conductor part is maintained at a constant potential.

6. The superconductive passive element according to claim 5, wherein
   the superconductor of the first conductor part is used as a superconducting transmission line for transmitting the high-frequency power.

7. The superconductive passive element according to claim 6, wherein

   the first conductor part and the second conductor part are arranged with a gap in between,
   a substance is placed in the gap, the substance being a substance that exhibits dielectric loss of less than a predetermined value determined due to an application filed of the superconductive passive element at the frequency of the high-frequency power.

8. The superconductive passive element according to claim 4, wherein

   the superconductor of the first conductor part is deposited on a surface of a first substrate, and
   the superconductor of the second conductor part is deposited on a surface of a second substrate, and
   the first substrate and the second substrate are fixed to each other so that the outermost surfaces when the superconductors of the first conductor part and the second conductor part are deposited face each other.

9. The superconductive passive element according to claim 8, wherein

   the second substrate has a recess formed therein, and
   the surface on which the superconductor for the second conductor part is deposited is a portion of inner surface of the recess of the second substrate, the portion of inner surface facing the surface of the first substrate..

10. The superconductive passive element according to any of claims 1 to 3, wherein at least one of the superconductors of the first conductor part and the superconductor of the second conductor part is made of at least one superconducting material selected from the superconducting material group consisting of Nb, Ta, Al, Ti, Hf, W, NbN, NbTi, TiN, NbTiN, $MgB_2$, YBCO, HBCCO, and BSCCO.

**11.** The superconductive passive element according to any of claims 1 to 3, wherein

the first conductor part and the second conductor part are placed across a gap, and
the superconductive passive element is used as a measurement cell for measuring the dielectric performance of a substance placed in the gap.

**12.** A superconducting resonator element comprising the superconductive passive element according to any of claims 1 to 3.

**13.** The superconducting resonator element according to claim 12, wherein the first conductor part and the second conductor part form a quarter-wave transmission line or a half-wave transmission line having either a microstrip line structure or a coplanar waveguide structure.

**14.** The superconducting resonator element according to claim 12, wherein the at least one of the first conductor part or the second conductor part forms an inductor and a capacitor having a meander structure

**15.** A method for manufacturing a superconductive passive element, comprising:
arranging a first conductor part including a superconductor in opposition to a second conductor part including a superconductor while keeping a distance from the second conductor part.

**16.** The method for manufacturing a superconductive passive element according to claim 15, further comprising the steps of:

depositing the superconductor on a first substrate to form the first conductor part having the superconductor; and
forming a second conductor part,
wherein the outermost surface of the first conductor part is an outermost surface at the time of deposition.

**17.** The method for manufacturing a superconductive passive element according to claim 16, wherein

the forming the second conductor part comprises depositing the superconductor on a second substrate to form the second conductor part having the superconductor, and
the arranging comprises arranging the first conductor part and the second conductor part with outermost surfaces when the superconductors are deposited facing each other and separated from each other.

**18.** The method for manufacturing a superconductive passive element according to claim 16, wherein the forming the first conductor part is to deposit the superconductor on the first substrate by means of either a vapor deposition method or a sputtering method to form the first conductor part having the superconductor.

**19.** The method for manufacturing a superconductive passive element according to claim 17, wherein the forming the second conductor part is to deposit the superconductor on the second substrate by means of either the vapor deposition method or the sputtering method to form the second conductor part having the superconductor.

**20.** The method for manufacturing a superconductive passive element according to claim 16, wherein the forming the first conductor part is to deposit the superconductor on the first substrate by means of an epitaxial growth method to form the first conductor part having the superconductor.

**21.** The method for manufacturing a superconductive passive element according to claim 17, wherein the forming the second conductor part is to deposit the superconductor on the second substrate by means of an epitaxial growth method to form the second conductor part having the superconductor.

**22.** The method for manufacturing a superconductive passive element according to claim 17, wherein the arrangement comprises fixing the first substrate and the second substrate in a manner that outermost surfaces when superconductors are deposited on the first conductor part and the second conductor part are facing each other.

**23.** The method for manufacturing a superconductive passive element according to claim 17, further comprising:

forming a recess in the second conductor part,
wherein the second substrate has a recess formed on it, and

the surface on which the superconductor for the second conductor part is deposited is a part of the inner surface of the recess of the second substrate that faces the surface of the first substrate.

24. An apparatus comprising a superconductive passive element according to any of claims 1 to 3.

## FIG. 1A

## FIG. 1B

*FIG. 2A*

*FIG. 2B*

**FIG. 3**

FIG. 4A

FIG. 4B

FIG. 4C

FIG. 4D

FIG. 4E

## FIG. 5A

## FIG. 5B

## FIG. 5C

**FIG. 6**

Resonator Sub.

| | |
|---|---|
| Resist Coating | ~S02 |

| | |
|---|---|
| Exposure/Develop. | ~S04 |

| | |
|---|---|
| Sup. Cond. Depo. | ~S06 |

| | |
|---|---|
| Lift-Off (Resist Removal) | ~S08 |

GND Sub.

| | |
|---|---|
| Resist Coating | ~S22 |

| | |
|---|---|
| Exposure/Develop. | ~S24 |

| | |
|---|---|
| Deep RIE | ~S26 |

| | |
|---|---|
| Resist Removal | ~S28 |

| | |
|---|---|
| Resist Coating | ~S42 |

| | |
|---|---|
| Exposure/Develop. | ~S44 |

| | |
|---|---|
| Sup. Cond. Depo. | ~S46 |

| | |
|---|---|
| Lift-Off (Resist Removal) | ~S48 |

~S52

| |
|---|
| Bonding |

End of Element Mfg

## FIG. 7

FIG. 8A

FIG. 8B

## FIG. 9A

## FIG. 9B

**FIG. 10A**

*T=300mK*

**FIG. 10B**

*T=300mK*

**FIG. 10C**

*T=300mK*

*FIG. 11A*

*T=4.2K*

*FIG. 11B*

*T=4.2K*

*FIG. 11C*

*T=4.2K*

## FIG. 12A

## FIG. 12B

## FIG. 12C

**INTERNATIONAL SEARCH REPORT**

| International application No. |
| --- |
| **PCT/JP2023/029041** |

| A. | CLASSIFICATION OF SUBJECT MATTER |
| --- | --- |

*H01P 7/08*(2006.01)i; *G01N 22/00*(2006.01)i; *H01P 1/203*(2006.01)i; *H01P 11/00*(2006.01)i; *H10N 60/10*(2023.01)i
FI:   H01P7/08; G01N22/00 K; G01N22/00 T; H01P1/203; H01P11/00 102; H10N60/10 Z

According to International Patent Classification (IPC) or to both national classification and IPC

| B. | FIELDS SEARCHED |
| --- | --- |

Minimum documentation searched (classification system followed by classification symbols)

    H01P7/08; G01N22/00; H01P1/203; H01P11/00; H10N60/10

Documentation searched other than minimum documentation to the extent that such documents are included in the fields searched

    Published examined utility model applications of Japan 1922-1996
    Published unexamined utility model applications of Japan 1971-2023
    Registered utility model specifications of Japan 1996-2023
    Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2000-278012 A (IDOTAI TSUSHIN SENTAN GIJUTSU KENKYUSHO KK) 06 October 2000 (2000-10-06) <br>     paragraphs [0017]-[0028], fig. 1-4 | 1-2, 4, 10, 15-16, 20 |
| Y | | 24 |
| A | | 3, 5-9, 11-14, 17-19, 21-23 |
| X | JP 9-321502 A (IDOTAI TSUSHIN SENTAN GIJUTSU KENKYUSHO KK) 12 December 1997 (1997-12-12) <br>     paragraphs [0010]-[0018], fig. 1-3, paragraphs [0024]-[0029], fig. 11, 12 | 1, 4, 6, 12, 14 |
| Y | JP 9-51127 A (MATSUSHITA ELECTRIC IND. CO., LTD.) 18 February 1997 (1997-02-18) <br>     paragraphs [0001], [0045]-[0063], fig. 1, 2 | 24 |

☐ Further documents are listed in the continuation of Box C.     ☑ See patent family annex.

| *   Special categories of cited documents: <br> "A"   document defining the general state of the art which is not considered to be of particular relevance <br> "E"   earlier application or patent but published on or after the international filing date <br> "L"   document which may throw doubts on priority claim(s) or which is cited to establish the publication date of another citation or other special reason (as specified) <br> "O"   document referring to an oral disclosure, use, exhibition or other means <br> "P"   document published prior to the international filing date but later than the priority date claimed | "T"   later document published after the international filing date or priority date and not in conflict with the application but cited to understand the principle or theory underlying the invention <br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other such documents, such combination being obvious to a person skilled in the art <br> "&"   document member of the same patent family |
| --- | --- |

| Date of the actual completion of the international search <br><br> **10 October 2023** | Date of mailing of the international search report <br><br> **24 October 2023** |
| --- | --- |
| Name and mailing address of the ISA/JP <br><br> **Japan Patent Office (ISA/JP)** <br> **3-4-3 Kasumigaseki, Chiyoda-ku, Tokyo 100-8915** <br> **Japan** | Authorized officer <br><br><br><br> Telephone No. |

Form PCT/ISA/210 (second sheet) (January 2015)

**INTERNATIONAL SEARCH REPORT**
Information on patent family members

International application No.

**PCT/JP2023/029041**

| Patent document cited in search report | | | Publication date (day/month/year) | Patent family member(s) | | | Publication date (day/month/year) |
|---|---|---|---|---|---|---|---|
| JP | 2000-278012 | A | 06 October 2000 | (Family: none) | | | |
| JP | 9-321502 | A | 12 December 1997 | (Family: none) | | | |
| JP | 9-51127 | A | 18 February 1997 | US | 6178339 | B1 | |
| | | | | fig. 1, 2 | | | |
| | | | | EP | 738021 | A2 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YASUNOBU NAKAMURA**. Chodendo Ryoshi Bitto Kenkyuu No Shinten To Oyo. *Progress and Applications of Superconducting Quantum Bit Research*, 2021, vol. 90 (4), 209
- **A. ROMANENKO** ; **A. GRASSELLINO** ; **A. C. CRAWFORD** ; **D. A. SEREGATSKOV** ; **O. MELNYCHUK**. Ultra-high quality factors in superconducting niobium cavities in ambient magnetic fields up to 10 mG. *Appl. Phys. Lett*, 2014, vol. 105, 234103

- **S. KONO** ; **K. KOSHINO** ; **Y. TABUCHI** ; **A. NOGUCHI** ; **Y. NAKAMURA**. Quantum non-demolition detection of an itinerant microwave photon. *Nature Physics*, 2018, vol. 14, 546-549
- **A. ENDO et al.** First light demonstration of the integrated superconducting spectrometer. *Nature Astronomy*, 2019, vol. 3, 989